# EUROPÄISCHE PATENTSCHRIFT

(11) **EP 1 299 941 B1**
(45) Veröffentlichungstag und Bekanntmachung des Hinweises auf die Patenterteilung: **03.11.2004**
(21) Anmeldenummer: 00949454.3
(22) Anmeldetag: 04.08.2000
(51) Int. Cl.: H03B 5/12, H03B 5/04

(54) **OSZILLATORSCHALTUNG**
OSCILLATOR CIRCUIT CONFIGURATION
MONTAGE OSCILLATEUR

(30) Priorität: 12.07.2000 DE 10033741
(43) Veröffentlichungstag der Anmeldung: 09.04.2003
(73) Patentinhaber: Synergy Microwave Corporation, Paterson, NJ 07504 (US)
(72) Erfinder: ROHDE, Ulrich L., New York, NY 07458 (US); DANZEISEN, Klaus, D-82166 Gräfelfing (DE)
(74) Vertreter: Körfer, Thomas, Dipl.-Phys.
(86) Internationale Anmeldenummer: PCT/EP2000/007578
(87) Internationale Veröffentlichungsnummer: WO 2002/005416

(56) Entgegenhaltungen:
- DE-A- 3 513 403

## Beschreibung

Die Erfindung betrifft eine Oszillatorschaltung laut Oberbegriff des Hauptanspruches.

Oszillatorschaltungen mit LC-Parallelschwingkreisen sind mit verschiedenartigen Rückkopplungsschaltungen bekannt. Ein Beispiel hierfür ist der sogenannte Colpitts-Oszillator, bei dem der Rückkopplungskreis zwischen dem aus einem oder mehreren Bipolar- oder Feldeffekttransistoren bestehenden Verstärkerelement und dem LC-Parallelschwingkreis durch Aufspaltung der Kapazität des Schwingkreises in zwei am Ende der Induktivität des Schwingkreises wirkende Kapazitäten erfolgt. Ein Problem bei solchen Oszillatorschaltungen sind deren Temperaturschwankungen, Schwankungen des Frequenzganges sowie des Amplitudenrauschens und des daraus resultierten Phasenrauschens. Diese Schwankungen sind im wesentlichen auf Änderungen des Arbeitspunktes des Verstärkerelementes zurückzuführen.

Es ist daher Aufgabe der Erfindung, eine Oszillatorschaltung zu schaffen, bei welcher der Arbeitspunkt mit einfachen Mitteln konstant gehalten werden kann, so daß die erwähnten Temperatur, Frequenzund Amplitudenschwankungen vermieden werden.

Diese Aufgabe wird ausgehend von einer Oszillatorschaltung laut Oberbegriff des Hauptanspruches durch dessen kennzeichnende Merkmale gelöst. Vorteilhafte Weiterbildungen ergeben sich aus den Unteransprüchen.

Zur Reduzierung des Temperaturganges der Schwingkreisgüte einer Oszillatorschaltung der eingangs erwähnten Art ist es aus der DE 35 13 403 A1 an sich bekannt, in Gegenreihenschaltung zur Spule des Parallelschwingkreises eine damit gekoppelte zweite Spule vorzusehen, welche dieselbe Größe der Induktivität wie die erste Spule besitzt und welche so vom Wechselstrom-Verlustwiderstand der zweiten Spule gesteuert ist, daß die Änderung des Verlustwiderstandes der ersten Spule kompensiert wird. Zu diesem Zweck ist diese zusätzliche zweite Spule über einen in Reihe geschalteten Kondensator mit dem Kollektor des Transistor-Verstärkerelements der Schaltung verbunden. Durch Anwendung dieser bekannten Schaltungstechnik und einer zusätzlichen Kompensationswicklung am Parallelschwingkreis jedoch mit der erfindungsgemäß definierten Zuführung der Kollektorspannung wird die störende Wirkung der parasitären Kollektorkapazität kompensiert, die einerseits aus einem internen Kapazitätsanteil des Halbleiters und gegebenenfalls auch Kapazitätsanteilen des Gehäuses und des übrigen Aufbaus besteht. Damit kann diese parasitäre Kollektorkapazität nicht mehr parallel zur Induktivität des Parallelschwingkreises wirken und so die Frequenz arbeits-punktabhängig ändern. Durch die erfindungsgemäße Maßnahme wird also eine Frequenzänderung durch Änderung der parasitären Kollektorkapazität des Verstärkerelementes vermieden und somit ein Oszillator mit hoher spektraler Reinheit geschaffen.

Bei Colpitts-Oszillatoren, deren bipolarer Verstärkungstransistor in Kollektorschaltung betrieben ist und der Kollektor an Masse liegt, wirkt die parasitären Kollektorkapazität zwar unverstärkt auf die Induktivität des Parallelschwingkreises, trotzdem ist die erfindungsgemäße Maßnahme auch bei solchen Oszillatorschaltungen sinnvoll. Besonders vorteilhaft ist die erfindungsgemäße Maßnahme jedoch bei solchen Oszillatorschaltungen, beispielsweise Colpitts-Oszillatoren, bei denen das Ausgangssignal am Kollektor des Verstärkungstransistors ausgekoppelt wird und damit der Kollektor nicht mehr an Masse liegt. Die parasitäre Kollektorkapazität wird in diesem Falle mit dem Verstärkungsfaktor multipliziert am Kollektor und damit um ein Mehrfaches erhöht an der Induktivität des Parallelschwingkreises. Sie kann gemäß der Erfindung trotzdem sehr einfach unterdrückt werden.

Eine andere Möglichkeit für die Stabilisierung des Arbeitspunktes und damit die Vermeidung der erwähnten Temperatur, Frequenz- und Amplitudenschwankungen besteht nach dem Anspruch 3 darin, daß der Kollektorstrom des Transistors über einen Regelverstärker konstant gehalten wird. Durch diese Regelung auf konstangen Kollektorstrom wird der Arbeitspunkt des Transistors konstant gehalten und es werden gleichzeitig trägernahe Wechselstromkomponenten ausgeregelt, die durch interne Störquellen des Transistors hervorgerufen werden. Durch die Stabilisierung des Arbeitspunktes werden auch eventuelle Stromflußwinkeländerungen bei Frequenzänderungen vermieden, die ihrerseits den Arbeitspunkt beeinflussen würden. Die Ausgangsamplitude des Oszillators ändert sich durch die Arbeitspunktstabilisierung bei einer Oszillatorverstimmung weniger als bei bekannten Schaltungen, beispielsweise nur um 1dB. Es werden nicht nur langsame Änderungen ausgeregelt, sondern auch Änderungen über eine Bandbreite, die von Gleichstrom bis zu einer durch den Regelverstärker bestimmten Grenzfrequenz gehen. Es können also auch relativ schnelle Änderungen des Arbeitspunktes des Transistors ausgeregelt werden und so eine Störmodulation verhindert werden. Damit wird auch das Amplitudenrauschen und auch ein eventuell dadurch erzeugtes Phasenrauschen reduziert. Als besonders vorteilhaft hat es sich erwiesen, sowohl für das Verstärkerelement des Oszillators und auch für die Verstärkerelemente des Regelkreises Transistoren vom gleichen Typ zu verwenden, beispielsweise bipolare Transistoren vom npn-Typ, was durch entsprechende Wahl der Topologie der Schaltung möglich ist.

Um das Phasenrauschen bei solchen Oszillatorschaltungen so gering wie möglich zu halten, wird gemäß einer Weiterbildung der Erfindung nach Unteranspruch 16 vorgeschlagen, parallel zur Basis-Emitter-Strecke des Transistors einen Serienschwingkreis zu schalten, der auf die doppelte Oszillatorfrequenz abgestimmt ist. Auf diese Weise wird die Aussteuerung des Verstärkerelements bei der ersten Oberwelle der Schwingfrequenz des Oszillators und damit auch das Phasenrauschen möglichst gering gehalten. Diese Maßnahme ist bei allen üblichen Oszillatorschaltungen anwendbar, wird jedoch in Kombination mit eine Oszillatorschaltung nach Anspruch 1 kombiniert angewendet, um so optimale Betriebsbedingungen zu schaffen.

Die Erfindung wird im Folgenden anhand schematischer Zeichnungen an Ausführungsbeispielen näher erläutert.

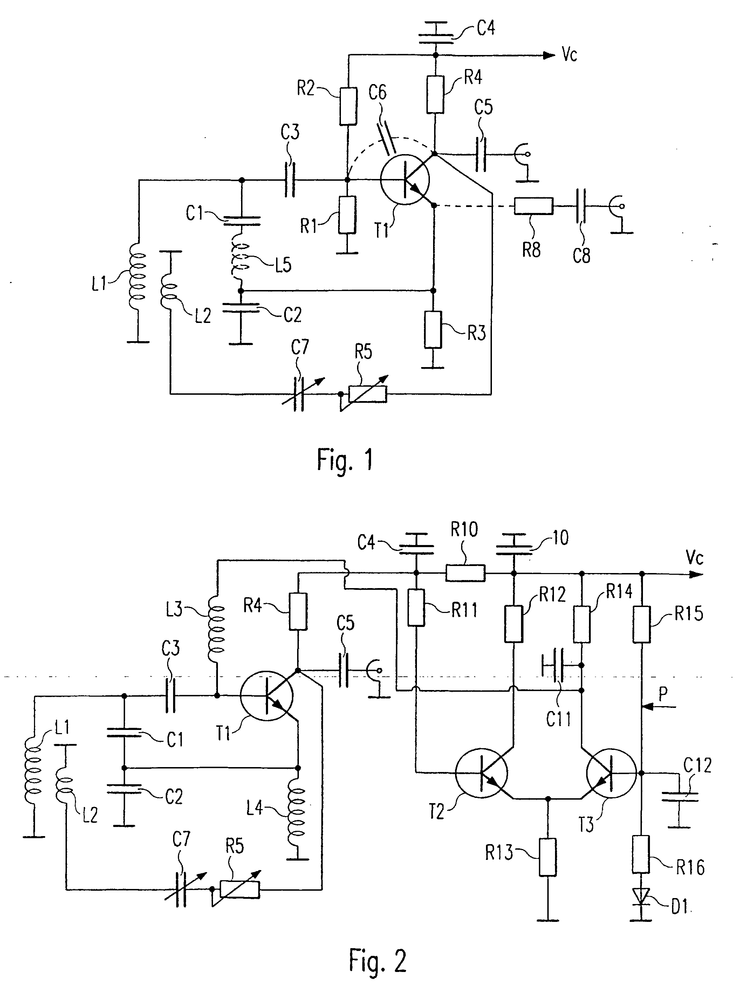

Figur 1 zeigt das Prinzipschaltbild eines Colpitts-Oszillators mit einem Parallelschwingkreis, bestehend aus einer Induktivität L1 und der Serienschaltung von zwei Kondensatoren C1 und C2. Als Verstärkerelement wird ein Transistor T1 benutzt, im gezeigten Ausführungsbeispiel ein bipolarer npn-Transistor. Durch L1 und C1/C2 wird die Schwingfrequenz des Oszillators bestimmt. Der Arbeitspunkt des Oszillators T1 wird bestimmt durch die Widerstände R1, R2 und R3. Über sie erfolgt auch die Zufuhr der Versorgungsspannung V_{c}. Wenn die Ausgangsfrequenz über den Kondensator C5 am Kollektor des Transistors T1 ausgekoppelt wird, ist zwischen Kollektor und dem Kondensator C4 ein den Ausgangswiderstand bestimmender Widerstand R4 vorgesehen. Wenn am Emitter des Transistors ausgekoppelt wird, wie dies in Figur 1 durch C8 und R8 gestrichelt angedeutet ist, ist dieser Widerstand R4 überflüssig und der Kollektor des Transistors T1 liegt über den Kondensator C4 direkt an Masse. Die Kondensatoren C3 und C4 sind Gleichspannungs-Trennkondensatoren, C4 ist ein hoch kapazitiver Kondensator zur Unterdrückung von niederfrequenten Störgeräuschen auf der Versorungsspannung V_{c}. Solche Störgeräusche könnten zu einer störenden Modulation der Oszillatorfrequenz führen.

Eine wesentliche Bedeutung hat die parasitären Kapazität C6, die aus einem internen Halbleiter-Kapazitäts-Anteil besteht, zu dem gegebenenfalls noch ein Kapazitätsanteil des umgebenden Gehäuses und von Teilen des übrigen Aufbaus hinzukommt. Diese parasitäre Kapazität C6 wird im Falle einer Spannungsverstärkung (Auskopplung über C5 direkt am Kollektor mit Widerstand R4 zwischen Kollektor und C4) am Kollektor mit dem Verstärkungsfaktor des Transistors T1 multipliziert und liegt damit also verstärkt parallel zur Induktivität L1 und bestimmt damit die Frequenz des Oszillators mit. Da dieser parasitäre Kapazitätsanteil C6 außerdem arbeitspunktabhängigen Schwankungen unterworfen ist, wird hierdurch auch die spektrale Reinheit der Frequenz beeinträchtigt. Wenn die Auskopplung, wie gestrichelt angedeutet, am Emitter erfolgt, wird dieser Verstärkungseffekt zwar vermieden, tritt jedoch auch hier in störendem Maße auf.

Um diesen Einfluß der parasitären Kollektorkapazität C6 zu vermeiden, ist erfindungsgemäß eine zusätzliche Kompensationswicklung L2 der Induktivität L1 des Parallelschwingkreises zugeordnet und mit dieser gekoppelt. Sie ist über einen einstellbaren Kondensator C7 und einen einstellbaren Widerstand R5 mit dem Kollektor des Transistors T1 verbunden, durch entsprechende Einstellung von C7 und R5 wird die Kollektorspannung des Transistors nach Betrag und Phase derart eingestellt der Kompensationswicklung L2 zugeführt, daß die geschilderte Wirkung der parasitären Kollektorkapazität C6 kompensiert wird.

Figur 2 zeigt die Schaltung eines Colpitt-Oszillators gemäß Figur 1, ergänzt durch eine zusätzliche Regelschaltung zum Konstanthalten des Gleichstrom-Arbeitspunktes und zur Ausregelung trägernaher Wechselstromkomponenten, die durch interne Störquellen des Transistors T1 hervorgerufen werden.

Die Oszillatorschaltung mit dem Parallelschwingkreis und dem bipolaren Transistor T1 entspricht der nach Figur 1. Zusätzlich ist noch ein Regelverstärker bestehend aus zwei Transistoren T2 und T3 vorgesehen. An der Serienschaltung des kleinen Widerstandes R4 von beispielsweise nur 50 Ohm und dem größeren Widerstand R5 von beispielsweise 1000 Ohm wird die durch den Kollektorstrom hervorgerufene Spannung über einen Widerstand R11 der Basis des ersten Transistors T2 zugeführt. Die Transistoren T2 und T3 haben einen gemeinsamen Emitterwiderstand R13 und zwei etwa gleich große Kollektorwiderstände R12 und R14. Die Basis des ersten Transistors T2 ist über R11 und R4 mit dem Kollektor des Transistors T1 verbunden, die Auskopplung erfolgt wieder über C5 am Kollektor von T1. Der Kollektor des zweiten Transistors T3 ist über einen Spule L3 mit der Basis des Transistors T1 verbunden. An der Basis des zweiten Transistors T3 wird über einen Spannungsteiler R15, R16 eine Referenzspannung erzeugt, wechselstrommäßig liegt die Basis des zweiten Transistors T3 über den Kondensator C12 an Masse.

Die Wirkungsweise dieses Regelverstärkers ist folgende:

Eine Reduzierung des Kollektorstromes des Transistors T1 bewirkt ein Ansteigen der Spannung an der Basis des Transistors T2, dadurch steigt der Strom durch den Transistor T2. Hierdurch steigt auch die Spannung am Widerstand R13 und hierdurch wird der Strom durch den Widerstand R14 reduziert. Damit steigt die Spannung am Kollektor dieses Transistors T3 und hierdurch wird über L3 der Strom durch den Transistor T1 erhöht, Damit stellt sich ein stabiler und temperaturunabhängiger Gleichstromzustand am Transistor T1 ein, der Arbeitspunkt wird also stabilisiert. Zusätzlich kann bei Frequenzänderungen ein sich ändernder Stromflußwinkel den Arbeitspunkt des Oszillators nicht mehr ändern. Als Folge davon ändert sich die Ausgangsamplitude des Oszillators bei Verstimmung ebenfalls weniger, z.B. nur um 1dB gegenüber bekannten Oszillatoren. Dies gilt nicht nur für langsame Schwankungen, sondern über eine Bandbreite, die von Gleichstrom bis zu einer Frequenz geht, die durch den Widerstand R14 und den Kondensator C11 bestimmt ist. Damit können auch relativ schnelle Änderungen des Arbeitspunktes des Transistors T1, die sonst zur Störmodulation führen würden, verhindert werden, also auch Amplitudenrauschen und ein dadurch erzeugtes Phasenrauschen.

Der Kondensator C12 sorgt dafür, daß das thermische Rauschen der Widerstände R15 und R16 sich nicht auf die Schaltung ungünstig auswirkt. Aus dem gleichen Grunde erfolgt die Zuführung des Basisstromes zum Transistor T1 über eine Induktivität.

Der Regelverstärker besitzt über seine Transistoren eine mehr oder weniger ausgeprägte Temperaturabhängigkeit, durch welche die Referenzspannung an der Basis des Transistors T3 beeinflußt wird. Um dies zu vermeiden, kann es vorteilhaft sein, den Spannungsteiler R15, R16 selbst entsprechend temperaturabhängig auszubilden und beispielsweise in Reihe zum Widerstand R16 eine Diode D1 anzuordnen. Durch geeignete Wahl der Temperaturcharakteristik dieser Diode D1 kann damit auch eine eventuelle Temperaturabhängigkeit des Transistors T1 ausgeglichen werden.

Durch die Stabilisierung des Arbeitspunktes über die Regelschaltung kann der Widerstand R3 gemäß Figur 1 entfallen und gemäß Figur 2 durch eine vorzugsweise gedruckte Induktivität L4 ersetzt werden, auf diese Weise kann eine weitere Geräuschquelle (thermisches Rauschen des Widerstandes R3) ausgeschaltet werden.

Anstelle von bipolaren Transistoren können auch Feldeffekttransistoren verwendet werden, in diesem Fall muß allerdings wieder ein Widerstand R1 gemäß Figur 1 am Transistor T1 vorgesehen werden, der bei dem stromgesteuerten Transistor T1 nach Figur 2 entfallen kann.

Es ist sinnvoll, die Topologie der Schaltung so zu wählen, daß technologisch gleiche aktive Bauelemente verwendet werden können und die gesamte Oszillatorschaltung in einfacher Weise als integrierter Schaltkreis ausgeführt werden kann. Dazu ist es beispielsweise vorteilhaft, in Figur 2 alle Transistoren T1, T2 und T3 als bipolare npn-Transistoren auszubilden.

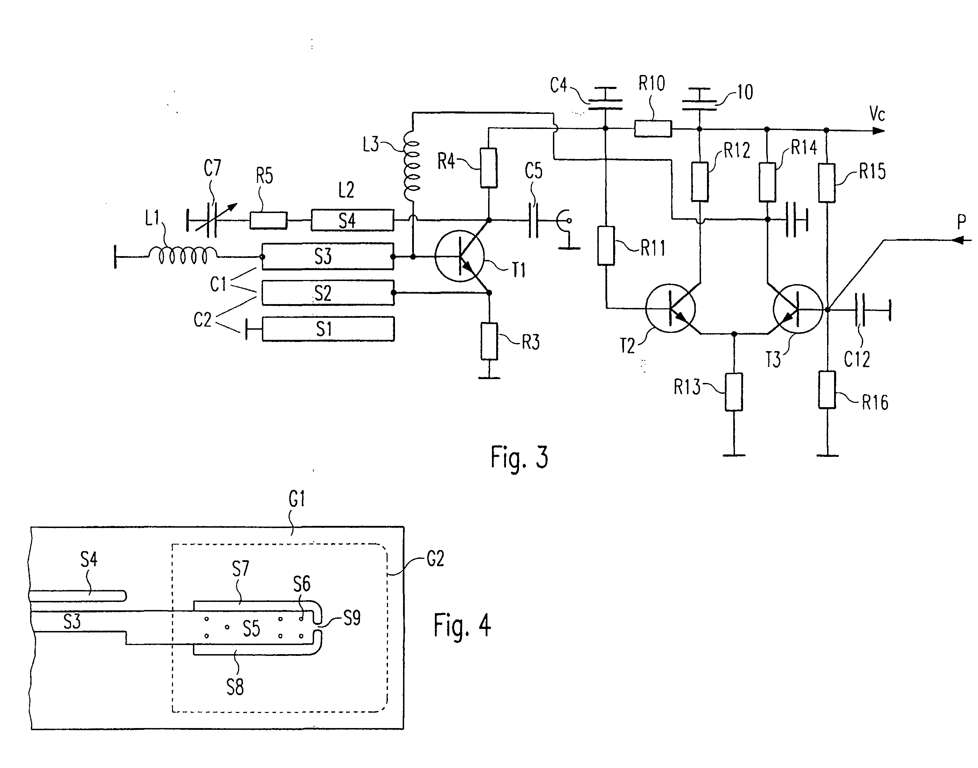

Figur 3 zeigt den Oszillatorteil der Schaltung nach Figur 2 in einer möglichen Realisierung für höhere Frequenzen. Die Kondensatoren C1 und C2 sind in diesem Beispiel als gekoppelte planare Streifenleiter S1, S2, S3 ausgebildet, die in vorbestimmten Abständen parallel nebeneinander in gedruckter Schaltungstechnik auf der Oberseite eines nicht dargestellten Schaltungsträgers ausgebildet sind. Sie wirken in bekannter Weise als koplanar verkoppelte Mikrostreifenleitungen und ersetzen bei geeigneter Dimensionierung ihrer Länge und Breite die diskreten Kondensatoren C1 und C2, die bei hohen Frequenzen in herkömmlicher Bauweise schlecht handhabbar sind, in kleinen Werten schlecht realisierbar sind und als einstellbare Kondensatoren meist überhaupt nicht zur Verfügung stehen. Die Kapazitätswerte solcher gekoppelter koplanarer Streifenleiter können einfach mittels geeigneter CAD-Programme berechnet und optimiert werden, sie können auch leicht abgeglichen werden und Fertigungstoleranzen sind gering. Außerdem ist die Herstellung solcher Kondensatoren sehr preiswert.

Auch eine sehr einfache Realisierung der Kompensationswicklung L2 ist gemäß Figur 3 durch einen solchen gekoppelten planaren Streifenleiter S4 möglich, der parallel zu dem den Kondensator C1 bildenden Streifenleiter S3 im Abstand angeordnet und über C1 mit L1 gekoppelt, ist.

Auch die frequenzbestimmende Induktivität L1 des Parallelschwingkreises kann auf einfache Weise in Leitungstechnik auf dem gleichen Schaltungsträger in gedruckter Schaltungstechnik realisiert werden, wie dies Figur 4 zeigt. Auf einem Substrat G1 sind auf der Ober- und Unterseite in Verlängerung des die Kapazität C1 bildenden Streifenleiters S3 gegenüberliegende Streifenleiter S5 ausgebildet, die über mehrere verteilte Durchkontaktierungen S6 galvanisch miteinander verbunden sind. Seitlich parallel zu diesen Streifenleitern S5 ist das Dielektrikum des Schaltungsträgers G1 in Form von Schlitzen S7 und S8 ausgefräst, nur am Ende der Streifenleiter S5 bleibt ein schmaler Materialsteg S9, der den ansonsten freitragenden Streifenleiter S5 am vorderen Ende mechanisch abstützt und damit ein mechanisches Schwingen dieses Teils verhindert. Der Schaltungsträger G1 ist in einem schematisch angedeuteten geschlossenen Gehäuse G2 eingebaut und das freitragende Leitungsstück S5 wirkt damit als Leitungsresonator. Die Dimensionierung (Länge, Breite, Dicke) dieses Resonators S5 erfolgt in bekannter Weise nach den für Topfkreise entwickelten Bemessungsvorschriften, da der Resonator S5 in dem Gehäuse G2 nichts anderes als ein üblicher Topfkreis ist. Durch diese Art der Ausbildung des Parallelschwingkreises werden hohe Eigengüten erreicht und damit eine wesentliche Verbesserung des Phasenrauschens des Oszillators.

Wenn die Frequenz des Parallelschwingkreises durch Kapazitätsdioden bestimmt werden soll, muß bei maximal erzielbarer Güte darauf geachtet werden, daß die Anzahl der Kapazitätsdioden auch güteoptimal gewählt wird. Optimale Güte wird nur erreicht, wenn entweder nur eine einzige Kapazitätsdiode verwendet wird oder zwei n-Paare von antiparallel geschalteten Kapazitätsdioden, wobei n größer als 1 sein muß und mit der Anzahl solcher in Serie geschalteter Kapazitätsdioden-Paare die Güte steigt.

Oszillatoren der beschriebenen Art werden oftmals in Phasenregelschleifen benutzt, in welchen die Oszillatorfrequenz in einem Phasendetektor mit einer Referenzfrequenz eines Referenzoszillators hoher Güte (beispielsweise Quarzoszillator), verglichen wird. In diesen Fällen kann es geschehen, daß das Rauschen der Referenzfrequenz höher ist als das der Oszillatorschaltung, nämlich dann, wenn trägernahes Rauschen der Referenzfrequenz über den Teilungsfaktor eines zwischengeschalteten Frequenzteilers hochmultipliziert wird. Damit wird dann die Oszillatorschaltung in Bezug auf das Phasenrauschen verschlechtert. Um dies zu vermeiden, kann es vorteilhaft sein, das Rauschen auf der Regelleitung über ein geeignetes Niederfrequenzfilter, beispielsweise einen Tiefpaß, in die Regelschaltung nach Figur 2 einzuspeisen, wie dies in Figur 2 über die Steuerleitung P schematisch angedeutet ist. Über dieses von der Regelleitung abgeleitete Regelsignal können solche störenden Rauschsignale auf der Regelleitung im Oszillator wieder ausgeregelt und damit die erwähnte Verschlechterung des Phasenrauschens kompensiert werden.

Zur Reduktion des Phasenrauschens ist es vorteilhaft, die Aussteuerung des Verstärkerelements T1 bei Frequenzen oberhalb der Oszillatorfrequenz möglichst gering zu halten. Dies kann dadurch erreicht werden, daß parallel zur Basis-Emitter-Strecke des Transistors T1 ein Serienresonanzkreis geschaltet wird, der auf die erste Oberwelle der Oszillatorfrequenz abgestimmt ist, wie dies in Fig. 1 durch die in Serie zum Kondensator C1 geschaltete, zusätzliche Spule L5 gestrichelt angedeutet ist. Da die erste Oberwelle im Allgemeinen die größte Amplitude nach der Grundwelle besitzt, kann hierdurch eine Verbesserung des Phasenrauschens um etwa 6 dB erreicht werden. Bei dem in Fig. 1 dargestellten Colpitts-Oszillator kann die eine Kapazität C1 für diesen zusätzlichen Serienresonanzkreis mit ausgenutzt werden, bei anderen Oszillatorschaltungen, bei denen keine derartige Aufspaltung der Schwingkreis-Kapazität in zwei in Serie geschaltete Kapazitäten C1, C2 vorgesehen ist, kann dieser zusätzliche Serienresonanzkreis mit Serienresonanz 2f zusätzlich zwischen Basis und Emitter des Transistors T1 angeordnet werden. Die Induktivität L5 wird vorzugsweise wieder in gedruckter Streifenleitungstechnik realisiert.

## Patentansprüche

1. Oszillatorschaltung mit einem LC-Parallelschwingkreis (L1, C1, C2), einem Transistor (T1) als Verstärkerelement und einer dem Parallelschwingkreis zugeordneten Kompensationswicklung (L2), der die Kollektorspannung des Transistors (T1) zugeführt wird,
**dadurch gekennzeichnet,**
**daß** die der Kompensationswicklung (L2) zugeführte Kollektorspannung nach Betrag und Phase so eingestellt ist, daß sie der Wirkung der parasitären Kollektorkapazität (C6) des Transistors (T1) entgegengesetzt ist.

2. Oszillatorschaltung nach Anspruch 1,
**dadurch gekennzeichnet,**
**daß** die Einstellung der Kollektorspannung nach Betrag und Phase über die Serienschaltung eines einstellbaren Kondensators (C7) und eines einstellbaren Widerstandes (R5) erfolgt.

3. Oszillatorschaltung nach Anspruch 1 oder 2,
**dadurch gekennzeichnet,**
**daß** der Kollektorstrom des Transistors (T1) über einen Regelverstärker (T2, T3) konstant gehalten wird.

4. Schaltung nach Anspruch 3,
**dadurch gekennzeichnet,**
**daß** der Regelverstärker aus zwei Transistoren (T2, T3) besteht, die einen gemeinsamen Emitterwiderstand (R13) und etwa jeweils gleiche Kollektorwiderstände (R12, R14) aufweisen, wobei die Basis des Eingangstransistors (T2) mit dem Kollektor des Oszillator-Transistors (T1) und der Kollektor des Ausgangstransistors (T3) mit der Basis des Oszillator-Transistors (T1) verbunden ist.

5. Schaltung nach Anspruch 4,
**dadurch gekennzeichnet,**
**daß** die Basis des Ausgangstransistors (T3) über einen Kondensator (C12) wechselstrommäßig an Masse liegt.

6. Schaltung nach Anspruch 4 oder 5,
**dadurch gekennzeichnet,**
**daß** der Kollektor des Ausgangstransistors (T3) über eine Induktivität (L3) mit der Basis des Oszillator-Transistors (T1) verbunden ist.

7. Schaltung nach einem der vorhergehenden Ansprüche 4 bis 6,
**dadurch gekennzeichnet,**
**daß** der an der Basis des Ausgangstransistors (T3) wirkende und die Referenz des Regelverstärkers bestimmende Spannungsteiler (R15, R16) temperaturabhängig ausgebildet ist (Diode D1).

8. Schaltung nach einem der vorhergehenden Ansprüche 3 bis 7,
**dadurch gekennzeichnet,**
**daß** der Emitter des Oszillator-Transistors (T1) über eine Induktivität (L4) an Masse liegt.

9. Schaltung nach einem der vorhergehenden Ansprüche 3 bis 8,
**dadurch gekennzeichnet,**
**daß** die Topologie der Oszillatorschaltung und des Regelverstärkers so gewählt ist, daß jeweils Transistoren von gleichem Typ benutzbar sind.

10. Schaltung nach Anspruch 9,
**dadurch gekennzeichnet,**
**daß** der Oszillatortransistor (T1) und auch die Transistoren des Regelverstärkers (T2, T3) bipolare Transistoren vom npn-Typ sind.

11. Schaltung nach einem der vorhergehenden Ansprüche 1 bis 10,
**dadurch gekennzeichnet,**
**daß** mindestens einige der verwendeten Kondensatoren aus gekoppelten koplanaren Streifenleitern (S1, S2, S3) bestehen.

12. Schaltung nach einem der vorhergehenden Ansprüche 1 bis 11,
**dadurch gekennzeichnet,**
**daß** der Parallelschwingkreis in Streifenleitungstechnik als Leitungsresonator ausgebildet ist.

13. Schaltung nach Anspruch 12,
**dadurch gekennzeichnet,**
**daß** der Leitungsresonator aus einem innerhalb eines geschlossenen Gehäuses (G2) angeordneten Schaltungsträger (G1) besteht, auf dessen Ober- und Unterseite identische Streifenleiter (S5) ausgebildet sind, die durch Durchkontaktierungen (S6) galvanisch miteinander verbunden sind und längs deren Ränder Längsschlitze (S7, S8) im Schaltungsträger ausgefräst sind.

14. Schaltung nach einem der vorhergehenden Ansprüche 1 bis 13,
**dadurch gekennzeichnet,**
**daß** der Parallelschwingkreis über mindestens eine parallel zur Induktivität (L1) angeordnete Kapazitätsdiode in der Frequenz abstimmbar ist, wobei entweder nur eine einzige Kapazitätsdiode oder 2n jeweils aus zwei antiparallel geschalteten Kapazitätsdioden bestehende und in Serie geschalteten Kapazitätsdioden-Paare vorgesehen sind mit n = 2,3,4....

15. Schaltung nach einem der vorhergehenden Ansprüche 1 bis 14,
**dadurch gekennzeichnet,**
**daß** sie als phasengeregelter Oszillator benutzt wird und ihre Ausgangsspannung in einem Phasendetektor mit einer Referenzfrequenz verglichen wird, wobei das Regelsignal der Regelschleife über ein Filter in den den Kollektorstrom des Oszillator-Transistors konstant haltenden Regelverstärker eingespeist wird und zwar in einem ein eventuelles Rauschen auf der Regelschleife ausregelnden Sinne.

16. Oszillatorschaltung nach Anspruch 1 und/oder Anspruch 3, **dadurch gekennzeichnet, daß** parallel zur Basis-Emitter-Strecke des Transistors (T1) ein auf die doppelte Oszillatorfrequenz abgestimmter Serienresonanzkreis (C1, L5) geschaltet ist.

17. Oszillatorschaltung nach Anspruch 16, für einen Colpitts-Oszillator, bei dem die Rückkopplung zwischen Emitter des Transistors (T1) und dem LC-Parallelschwingkreis durch Aufspalten der Schwingkreiskapazität in zwei in Serie geschaltete Kapazitäten (C1, C2) erfolgt,
**dadurch gekennzeichnet,**
**daß** der Serienresonanzkreis durch eine in Serie zu der einen Schwingkreiskapazität (C1) geschaltete Induktivität (L5) gebildet ist.

18. Schaltung nach Anspruch 16 oder 17,
**dadurch gekennzeichnet,**
**daß** die Induktivität (L5) des Serienresonanzkreises in Streifenleitungstechnik ausgebildet ist.

## Claims

1. Oscillator circuit with an LC-parallel resonant circuit (L1, C1, C2), a transistor (T1) as an amplifier element, and a compensation coil (L2) which is allocated to the parallel resonant circuit and to which the collector voltage of the transistor (T1) is fed,
**characterised in that**
the collector voltage fed to the compensation coil (L2) is adjusted in amount and phase so that it opposes the effect of the parasitical collector capacitor (C6) of the transistor (T1)

2. Oscillator circuit according to Claim 1,
**characterised in that**
the collector voltage is adjusted in amount and phase via the series circuit of a variable capacitor (C7) and a variable resistor (R5).

3. Oscillator circuit according to Claim 1 or 2,
**characterised in that**
the collector current of the transistor (T1) is kept constant via a controlled gain amplifier (T2, T3).

4. Circuit according to Claim 3,
**characterised in that**
the controlled gain amplifier consists of two transistors (T2, T3), which have a common emitter resistor (R13) and in each case roughly equal collector resistors (R12, R14), whereby the base of the input transistor (T2) is connected with the collector of the oscillator-transistor (T1) and the collector of the output transistor (T3) with the base of the oscillator-transistor (T1).

5. Circuit according to Claim 4,
**characterised in that**
the base of the output transistor (T3) is earthed AC-wise via a capacitor (C12).

6. Circuit according to Claim 4 or 5,
**characterised in that**
the collector of the output transistor (T3) is connected via an inductor (L3) with the base of the oscillator-transistor (T1)

7. Circuit according to one of the previous Claims 4 to 6,
**characterised in that**
the voltage splitter (R15, R16) acting on the base of the output transistor (T3) and determining the reference of the controlled gain amplifier is designed dependent on temperature (diode D1).

8. Circuit according to one of the previous Claims 3 to 7,
**characterised in that**
the emitter of the oscillator-transistor (T1) is earthed via an inductor (L4).

9. Circuit according to one of the previous Claims 3 to 8,
**characterised in that**
the topology of the oscillator circuit and the controlled gain amplifier is selected so that transistors of the same type can be used.

10. Circuit according to Claim 9,
**characterised in that**
the oscillator-transistor (T1) and also the transistors of the controlled gain amplifier (T2, T3) are bipolar transistors of the npn type.

11. Circuit according to one of the previous Claims 1 to 10,
**characterised in that**
at least some of the capacitors used consist of coupled coplanar microstrips (S1, S2, S3).

12. Circuit according to one of the previous Claims 1 to 11,
**characterised in that**
the parallel resonant circuit is designed in stripline technology as a conductor resonator.

13. Circuit according to Claim 12,
**characterised in that**
the conductor resonator consists of a circuit board (G1) arranged inside a closed housing (G2) on the top and bottom of which identical microstrips (S5) are laid, which are then galvanically connected with one another by feedthroughs (S6) and along their edges longitudinal slits (S7, S8) are machined out in the circuit board.

14. Circuit according to one of the previous Claims 1 to 13,
**characterised in that**
the parallel resonant circuit can be tuned in the frequency via at least one capacitance diode connected in parallel to the inductor (L1), whereby either only a single capacitance diode or 2n capacitance diode pairs in each case consisting of two antiparallel connected capacitance diodes and connected in series are provided where n = 2,3,4 ....

15. Circuit according to one of the previous Claims 1 to 14,
**characterised in that**
it is used as a phase-regulated oscillator and its output voltage is compared in a phase detector with a reference frequency, whereby the control signal is fed to the control loop via a filter in the controlled gain amplifier keeping the collector current of the oscillator-transistor constant and to be precise in a direction fully stabilizing any noise on the control loop.

16. Oscillator circuit according to Claim 1 and/or Claim 3,
**characterised in that**
a series resonant circuit (C1, L5) tuned to the doubled oscillator frequency is connected in parallel to the base emitter section of the transistor (T1)

17. Oscillator circuit according to Claim 16, for a Colpitts oscillator, in which the feedback between the emitter of the transistor (T1) and the LC-parallel resonant circuit results from splitting the resonant circuit capacitance into two capacitors (C1, C2) connected in series, **characterised in that**
the series resonant circuit is formed by an inductor (L5) connected in series to the one resonant circuit capacitor (C1).

18. Circuit according to Claim 16 or 17,
**characterised in that**
the inductor (L5) of the series resonant circuit is designed in stripline technology.

## Revendications

1. Montage oscillateur ayant un circuit oscillant parallèle LC (L1, C1, C2), un transistor (T1) en tant qu'amplificateur et un enroulement tertiaire (L2) affecté au circuit oscillant parallèle qui transporte la tension de collecteur du transistor (T1),
**caractérisé en ce que**
la tension de collecteur transportée vers l'enroulement tertiaire (L2) est réglée en fonction de la valeur et de la phase de façon à être opposée à l'action de la capacité collecteur parasitaire (C6) du transistor (T1).

2. Montage oscillateur selon la revendication 1,
**caractérisé en ce que**,
le réglage de la tension collecteur en fonction de la valeur et de la phase est assuré par le montage en série d'un condensateur réglable (C7) et d'une résistance réglable (R5).

3. Montage oscillateur selon la revendication 1 ou 2,
**caractérisé en ce que**
le courant collecteur du transistor (T1) est maintenu constant par l'intermédiaire d'un amplificateur de réglage (T2, T3).

4. Montage oscillateur selon la revendication 3,
**caractérisé en ce que**,
l'amplificateur de réglage est constitué de deux transistors (T2, T3) qui présentent une résistance d'émetteur (R13) commune et des résistances de collecteur (R12, R14) approximativement identiques, la base du transistor d'entrée (T2) étant reliée au collecteur du transistor oscillateur (T1) et le collecteur du transistor de sortie (T3) à la base du transistor oscillateur (T1).

5. Montage selon la revendication 4,
**caractérisé en ce que**,
la base du transistor de sortie (T3) est à la masse en ce qui concerne le courant alternatif par l'intermédiaire d'un condensateur (C12).

6. Montage selon la revendication 4 ou 5,
**caractérisé en ce que**
le collecteur du transistor de sortie (T3) est relié à la base du transistor oscillateur (T1) par l'intermédiaire d'une inductance (L3).

7. Montage selon l'une quelconque des revendications précédentes 4 à 6,
**caractérisé en ce que**,
le diviseur de tension (R15, R16) agissant sur la base du transistor de sortie (T3) et déterminant la référence de l'amplificateur de réglage dépend de la température (diode D1).

8. Montage selon l'une quelconque des revendications précédentes 3 à 7,
**caractérisé en ce que**,
l'émetteur du transistor oscillateur (T1) est à la masse par l'intermédiaire d'une inductance (L4).

9. Montage selon l'une quelconque des revendications précédentes 3 à 8,
**caractérisé en ce que**,
la topologie du montage oscillateur et de l'amplificateur de réglage est choisie de manière à ce que les transistors de même type puissent être utilisés.

10. Montage selon la revendication 9,
**caractérisé en ce que**,
le transistor oscillateur (T1) et les transistors de l'amplificateur de réglage (T2, T3) sont des transistors bipolaires du type npn.

11. Montage selon l'une quelconque des revendications précédentes 1 à 10,
**caractérisé en ce que**,
au moins certains des condensateurs utilisés sont constitués de microrubans coplanaires couplés (S1, S2, S3).

12. Montage selon l'une quelconque des revendications précédentes 1 à 11,
**caractérisé en ce que**,
le circuit oscillant parallèle conçu selon la technique de la ligne à rubans est configuré comme résonateur de ligne.

13. Montage selon la revendication 12,
**caractérisé en ce que**,
le résonateur de ligne est constitué d'un porte-circuit (G1) disposé à l'intérieur d'un boîtier (G2) fermé sur les côtés supérieur et inférieur duquel se trouvent des microrubans (S5) identiques qui sont reliés galvaniquement ensemble par des trous métallisés (S6) et des fentes longitudinales (S7, S8) et sont fraisées le long de leurs bords dans le porte-circuit.

14. Montage selon l'une quelconque des revendications précédentes 1 à 13,
**caractérisé en ce que**,
le circuit oscillant parallèle peut être syntonisé dans la fréquence par au moins une diode de capacité disposée parallèlement à l'inductance (L1), une seule diode de capacité ou 2n paires de diodes de capacité constituées chacune de deux diodes de capacités commutées en antiparallèle et en série étant prévues avec n = 2, 3, 4 ...

15. Montage selon l'une quelconque des revendications précédentes 1 à 14,
**caractérisé en ce que**,
il peut être utilisé en tant qu'oscillateur à réglage de phases et sa tension de sortie comparée à une fréquence de référence dans un détecteur de phase, le signal de réglage de boucle de réglage étant alimenté par l'intermédiaire d'un filtre vers l'amplificateur de réglage maintenant constant le courant collecteur du transistor oscillateur et ce dans le sens d'un réglage d'un éventuel souffle sur la boucle de réglage.

16. Montage oscillateur selon la revendication 1 et/ou la revendication 3, **caractérisé en ce qu'**un circuit de résonance en série syntonisé à la fréquence d'oscillateur double est commuté en parallèle au trajet base-émetteur du transistor (T1).

17. Montage oscillateur selon la revendication 16, pour un oscillateur Colpitt, sur lequel la rétroaction entre l'émetteur du transistor (T1) et le circuit oscillant parallèle LC est assurée par la division de la capacité du circuit oscillant en deux capacités commutées en série (C1, C2),
**caractérisé en ce que**,
le circuit de résonance en série est formé par une inductance (L5) commuté en série vers une capacité du circuit oscillant (1).

18. Montage selon la revendication 16 ou 17,
**caractérisé en ce que**
l'inductance (L5) du circuit de résonance en série est configurée selon la technique de la ligne à rubans.
